# EUROPEAN PATENT SPECIFICATION

(11) **EP 2 954 093 B1**
(45) Date of publication and mention of the grant of the patent: **01.05.2019**
(21) Application number: 14704645.2
(22) Date of filing: 10.02.2014
(51) Int. Cl.: C23C 16/455

(54) **INJECTOR AND METHOD**
INJEKTOR UND VERFAHREN
INJECTEUR ET PROCÉDÉ

(30) Priority: 08.02.2013 GB 201302306
(43) Date of publication of application: 16.12.2015
(73) Proprietor: Scanwel Limited, Bala Gwynedd LL23 7HW (GB)
(72) Inventor: BARRIOZ, Vincent, Colwyn Bay Clwyd LL28 5YH (GB); LAMB, Dan Ash, Menai Bridge Gwynedd LL59 5YH (GB); MONIR, Shafiul, Abergele Clwyd LL22 7RU (GB); TRUEMAN, Steven, Blaenau Ffestiniog Gwynedd LL41 4AA (GB); KARTOPU, Giray, Chester Cheshire CH1 5ED (GB); OWEN, Ian Wynne, Corwen Clwyd LL23 7HW (GB); IRVINE, Stuart James Curzon, St Asaph Clwyd LL17 0UN (GB); YANG, Xiaogang, Wrexham Clwyd LL11 2RB (GB)
(74) Representative: Yeadon IP Limited
(86) International application number: PCT/GB2014/050386
(87) International publication number: WO 2014/122484

(56) References cited:
- US-A- 5 647 945
- US-A- 6 059 885
- US-A1- 2002 170 484
- US-A1- 2004 129 211
- US-A1- 2008 093 341
- US-A1- 2012 129 296
- US-B2- 8 318 611

## Description

### FIELD OF THE INVENTION

The present invention relates to gas delivery apparatus for a material deposition system and to a method of delivering gas in such a system.

### BACKGROUND

It is known to grow a thin film of a material on a substrate by establishing a flow of a gaseous precursor compounds over the substrate. Such systems may be referred to as gas deposition systems and include vapour phase epitaxy (VPE) systems, chemical vapour deposition (CVD) systems such as metal-organic CVD (MOCVD) systems, atmospheric pressure MOCVD systems (AP-MOCVD) and the like. The substrate is heated to promote decomposition of the precursor and increase the rate of deposition of material on the substrate. The gaseous precursor compounds are typically delivered to the substrate through one or more nozzles in front of the substrate. A curtain of inert gas may be established around the substrate. The curtain is intended to confine the gaseous precursor to the vicinity of the substrate. A problem with known nozzle arrangements is that the uniformity of thickness and chemical composition of layers formed on the substrate is highly dependent on the uniformity of gas flow over the substrate.

US5647945 discloses a vacuum processing apparatus that includes: a vacuum processing chamber for processing a target object; a processing gas supply source for supplying a processing gas by which a process is performed to the target object in the vacuum processing chamber; a processing gas supply pipe for supplying the processing gas from the processing gas supply source into the vacuum processing chamber; and a pressure reducing valve for keeping the gas supply pipe at a lower pressure than the atmospheric pressure when the processing gas is to be supplied to the vacuum processing chamber.

It is desirable to provide improved uniformity of material deposited in a material deposition system.

### STATEMENT OF THE INVENTION

Embodiments of the invention may be understood with reference to the appended claims.

Aspects of the present invention provide an injector, a system and a method.

In an aspect of the invention for which protection is sought there is provided an injector for injecting a gas in a materials deposition system, the injector comprising: a gas inlet port for coupling the injector to a gas source; a distribution chamber, an intermediate chamber and a delivery manifold coupled in series to provide a flowpath for the gas between the inlet port and at least one delivery aperture through which the gas is injectable in the deposition system, the injector having at least a first distribution chamber outlet aperture through which gas may flow from the distribution chamber to the intermediate chamber and at least first and second intermediate chamber outlet apertures through which gas may flow from the intermediate chamber to the delivery manifold, the intermediate chamber being arranged to divide a flow of gas therethrough between first and second flowpaths, the first and second intermediate chamber outlet apertures being provided in the respective flowpaths, the injector being arranged to allow the first and second flowpaths to converge within the delivery manifold,
wherein each one of the distribution chamber aperture, intermediate chamber aperture and delivery manifold aperture is elongate in shape,
wherein the first distribution chamber outlet aperture has a longitudinal axis disposed substantially parallel to an x-axis of the injector,
wherein the first and second intermediate chamber outlet apertures each have a longitudinal axis disposed substantially parallel to the x-axis of the injector, and
wherein longitudinal axes of the first substantially elongate distribution chamber outlet aperture and the first and second elongate intermediate chamber outlet apertures define the apices of an equilateral triangle as viewed along a direction parallel to the x-axis.

It is to be understood that the distribution chamber may be considered to provide an expansion chamber in which a pressure of gas entering the distribution chamber decreases as a consequence of expansion of the gas.
By longitudinal axis of an aperture is meant an axis passing through points at substantially opposite ends of the aperture. An elongate aperture may be considered to have ends through which the longitudinal axis passes that are disposed a greatest distance apart. In the case of a substantially symmetrical elongate aperture the longitudinal axis may coincide with a long axis of symmetry of the aperture (defined by a boundary of the body defining the aperture).

Thus the apertures may be considered to be disposed symmetrically about a line passing through the first distribution chamber outlet aperture and midway between the first and second intermediate chamber outlet apertures. The line may be arranged to be substantially normal to a plane of the first distribution chamber outlet aperture.

Optionally, at least the distribution chamber may be arranged to allow expansion of gas entering therein and/or passage of gas therethrough.

The gas may be a mixture of gases.

The gas injected may be a volume or body of gas.

The volume or body of gas may have a shape defined by the shape of the at least one delivery aperture through which the gas is injectable.

The volume or body of gas may take the form of a curtain or blade or other elongate volume or body.

By curtain or blade is meant that the volume or body of gas is relatively narrow in one direction or dimension, which may be referred to as a width dimension, and relatively wide in a direction or dimension orthogonal thereto, which may be referred to as a length direction. The width direction may be referred to as a z-direction with respect to orthogonal Cartesian coordinates whilst the length direction by referred to as an x-direction. By relatively wide and relatively narrow is meant that an aspect ratio of the length to the width is at least 5, optionally at least 10.

The curtain or blade may be relatively wide and relatively narrow in orthogonal directions that are each orthogonal to a direction of flow of gas from the delivery aperture.

Embodiments of the invention have the advantage that a volume such as a curtain or blade of gas of high flow uniformity along a length thereof may be generated at the at least one delivery aperture. This is believed to be at least in part because the injector is configured to manage expansion of gas entering the inlet port such that a uniform, stable flow of gas is established at the delivery aperture which may be elongate as described blow. The injector achieves this by allowing controlled expansion of gas in the distribution chamber, causing division of the flow of gas through the intermediate chamber and recombining the flow in the delivery manifold to create the blade of gas at the delivery aperture. By dividing the flow of gas between the first and second flowpaths and recombining the flowpaths in the delivery manifold excellent uniformity of gas flow through the delivery aperture may be achieved.

It is to be understood that injectors according to embodiments of the present invention may be used to inject precursor gas into a material deposition system. The high uniformity of gas flow across the flowpath of gas out from the delivery manifold enables more highly uniform layers of material to be deposited on a substrate than is achievable with known systems operating under similar conditions.

The precursor gas may be a mixture of gases. The precursor gas may be arranged to react when heated, to form a deposit on a substrate. The precursor gas may be arranged to be of a composition such that a plurality of respective components thereof react with one another and form a deposit on a substrate. Respective gases may be introduced from respective sources and fed into the injector. Precursor gas entering the injector may be arranged to undergo mixing in the injector when expansion of the gas in the distribution chamber takes place. This may be advantageous in ensuring uniformity of composition of gas injected by the injector.

Furthermore, some embodiments of the present invention may be used to generate a curtain of inert gas around a substrate for containment of precursor gases, the curtain being disposed between a deposition region in which deposition takes place and an external environment. The curtain may be used to prevent leakage of precursor gas from the deposition region of the system to the external environment. Furthermore, the curtain may be useful in preventing flow or ingress of oxygen or other gases from the external environment to the deposition region.

Some embodiments of the present invention are suitable for use in material deposition systems not employing evacuated deposition chambers, but which operate substantially at atmospheric pressure. Accordingly, some embodiments of the present invention are suitable for substantially continuous deposition processes as well as batch deposition processes. An example of a substantially continuous deposition process is a roll-to-roll process. In one example of such a process, a length of substrate material in roll form is unwound from a supply roll, passed through the deposition system and is then wound onto a collection roll. As substrate material that has passed through the deposition system is wound onto the collection roll, fresh substrate material is unwound from the supply roll.

In another example of a substantially continuous deposition process, substrates may be conveyed through the deposition system on a conveyor such as a continuous belt conveyor, a track carrying one or more substrate holders on wheels or rollers, or other structure.

It is to be understood that deposition systems that require a substrate to be placed inside a chamber, such as a vacuum chamber of high pressure chamber, or even an atmospheric pressure chamber, are not suitable for substantially continuous processing since the chamber must be sealed before deposition takes place, and unsealed after deposition has taken place. Some embodiments of the present invention make substantially continuous, atmospheric pressure processing possible even when hazardous gases are employed because a substantially continuous curtain of substantially harmless gas such as nitrogen may be established around the deposition region so as substantially to prevent escape of gas from the deposition region to atmosphere. Similarly, the curtain may prevent gases present in the atmosphere from diffusing into the deposition region and contaminating material that is being grown.

The delivery aperture through which the gas is injectable in the deposition system may be provided in or by the delivery manifold.

Two or more of the distribution chamber, intermediate chamber and delivery manifold may be elongate in substantially the same direction. That is, longitudinal axes may be substantially parallel.

Optionally, each one of the distribution chamber, intermediate chamber and delivery manifold is elongate in shape.

Each one of the distribution chamber aperture, intermediate chamber aperture and delivery manifold aperture may be in the form of a slit.

Alternatively, one or more of the distribution chamber aperture, intermediate chamber aperture and delivery manifold aperture may be provided by a foraminate or perforated body in which the aperture is provided. The perforations may be referred to as sub-apertures.

One or more of the distribution chamber aperture, intermediate chamber aperture and delivery manifold aperture may comprise an array of a plurality of sub-apertures or perforations in the body providing the aperture.

Optionally the array may be linear.

Sub-apertures or perforations within the array may be regularly arranged.

Optionally, at least one of the distribution chamber aperture, intermediate chamber aperture and delivery manifold aperture is elongate in shape.

Two or more of the apertures may be elongate in substantially the same direction. That is, longitudinal axes of the two or more elongate apertures may be substantially parallel.

Advantageously the flow of gas through the intermediate chamber may be divided substantially equally between the first and second flowpaths.

This feature advantageously further enhances stability and uniformity of gas flow out from the injector.

By stability is meant that the velocity of gas flow out from the delivery aperture is substantially constant along a length of the aperture. By uniformity is meant that a density of gas flowing through the aperture is substantially constant along the length of the aperture.

The flow of gas through the intermediate chamber may be divided between the first and second flowpaths by baffle means.

The baffle means may be provided by a wall of the intermediate chamber disposed between the first and second intermediate chamber outlet apertures and dividing the intermediate chamber from the delivery manifold.

The injector may be arranged wherein a distribution chamber aperture plate is provided between the distribution chamber and intermediate chamber, the distribution chamber aperture plate having the first distribution chamber outlet aperture provided therein.

Optionally, the x-axis of the injector is coincident with or substantially parallel to a longitudinal axis of the injector. Thus the first distribution chamber outlet aperture may be substantially parallel to a longitudinal axis of the injector.

Optionally the distribution chamber, intermediate chamber and delivery manifold each have substantially parallel longitudinal axes.

The longitudinal axes may be substantially parallel to the x-axis of the injector.

The injector may comprise a plurality of distribution chamber outlet apertures provided at spaced apart locations.

The plurality of distribution chamber outlet apertures may be substantially collinear.

By substantially collinear is meant that the apertures have longitudinal axes that are provided along a common line. That is, the apertures have longitudinal axes that substantially coincide.

A length of each distribution chamber outlet aperture may decrease as a function of distance from the inlet port.

This feature has the advantage that uniformity of flow along the length of the injector may be improved by providing apertures having different lengths. Since pressure decreases as a function of distance from the inlet port, a length of respective apertures increases as a function of distance of an aperture from the inlet port. This increases a uniformity of flow along the length of the injector.

Advantageously the injector may comprise first and second respective portions each having a distribution chamber, an intermediate chamber and a distribution chamber, each portion further comprising at least one distribution chamber outlet aperture and at least first and second elongate intermediate chamber outlet apertures, wherein gas entering the injector through the gas inlet port is divided between the distribution chambers of the first and second portions.

The first and second portions may share a common longitudinal axis.

The respective intermediate chambers may be separated from one another by barrier means.

Alternatively or in addition the first and second portions may share a common distribution chamber.

The first and second portions may share a common delivery manifold.

The first and second portions may share a common delivery aperture.

The first and second portions may share a common inlet port.

The injector may be arranged to be substantially symmetrical about a plane normal to a longitudinal axis thereof between the first and second portions.

The longitudinal axis may be parallel to or coincident with the x-axis referenced above.

As noted above at least one of the apertures may comprise a plurality of smaller sub-apertures or perforations.

The plurality of sub-apertures or perforations may be substantially circular.

In one aspect of the invention for which protection is sought there is provided a coating head comprising an injector according to a preceding aspect.

In a further aspect of the invention for which protection is sought there is provided a material deposition system comprising a deposition region or zone in which deposition of material takes place on a substrate and at least one injector according to a preceding aspect.

The system may comprise at least one injector arranged to inject deposition gas into the deposition region, the deposition gas comprising material to be deposited on a substrate.

The gas may be arsine gas and trimethyl gallium for example, therefore comprising gallium and arsenic for deposition on the substrate, for example in the form of gallium arsenide (GaAs).

The system may comprise at least one injector operable to provide a volume of gas defining a curtain separating the deposition region from an environment external thereto, the curtain being arranged to reduce leakage of deposition gas from the deposition region.

The volume of gas injected may be in the form of a blade of gas.

The system may comprise a plurality of injectors defining a curtain around the deposition region.

In an aspect of the invention for which protection is sought there is provided a method of injecting gas in a materials deposition system by means of an injector, comprising: establishing a flow of gas through the injector from a gas inlet to a delivery aperture thereof whereby the gas flows through a distribution chamber, an intermediate chamber and a delivery manifold coupled in series, the method comprising allowing the gas to expand within the distribution chamber and to pass through at least a first distribution chamber outlet aperture into the intermediate chamber, the flow of gas being arranged to flow along one of a first and a second flowpath through a first or a second intermediate chamber outlet aperture provided in the first and second flowpaths respectively, the method comprising allowing the first and second flowpaths to converge within the delivery manifold, wherein the method further comprises:
providing the first distribution chamber outlet aperture whereby the aperture has a longitudinal axis disposed substantially parallel to an x-axis of the injector;
providing the first and second intermediate chamber outlet apertures whereby each has a longitudinal axis disposed substantially parallel to the x-axis of the injector; and
providing the first substantially elongate distribution chamber outlet aperture and the first and second elongate intermediate chamber outlet apertures such that longitudinal axes thereof define the apices of an equilateral triangle as viewed along a direction parallel to the x-axis.

Optionally, establishing the flow of gas through a distribution chamber, an intermediate chamber and a delivery manifold comprises establishing the flow of gas through a substantially elongate distribution chamber, a substantially elongate intermediate chamber and a substantially elongate delivery manifold,

Further optionally, establishing a flow of gas through the injector from a gas inlet to a delivery aperture comprises establishing a flow of gas through the injector from a gas inlet to an elongate delivery aperture and allowing a gas to pass through at least a first distribution chamber outlet aperture comprises allowing a gas to pass through at least a first substantially elongate distribution chamber outlet aperture.

The method may comprise causing the flow of gas in use through the intermediate chamber to be divided substantially equally between the first and second flowpaths.

The method may comprise causing the flow of gas through the intermediate chamber to be divided between the first and second flowpaths by baffle means.

The method may comprise providing the baffle means in the form of a wall of the intermediate chamber disposed between the first and second intermediate chamber outlet apertures and dividing the intermediate chamber from the delivery manifold.

The method may comprise causing the gas to flow through a first distribution chamber outlet aperture provided in a distribution chamber aperture plate, the distribution chamber aperture plate being provided between the distribution chamber and intermediate chamber.

The method may comprise providing the distribution chamber, intermediate chamber and delivery manifold such that they have substantially parallel longitudinal axes.

The method may comprise providing the distribution chamber, intermediate chamber and delivery manifold such that their longitudinal axes are substantially parallel to the x-axis of the injector.

The method may comprise providing a plurality of distribution chamber outlet apertures at spaced apart locations.

The method may comprise providing the plurality of distribution chamber outlet apertures to be substantially collinear.

Optionally, the at least one delivery aperture is provided in a wall of the delivery manifold.

Advantageously, the distribution chamber may be arranged to allow expansion of gas entering therein, the injector having at least a first substantially elongate distribution chamber outlet aperture through which gas may flow from the distribution chamber to the intermediate chamber.

The injector may comprise first and second elongate intermediate chamber outlet apertures through which gas may flow from the intermediate chamber to the delivery manifold.

The distribution chamber outlet aperture and the intermediate chamber outlet apertures may be arranged wherein gas flowing through the distribution chamber outlet aperture flows towards a baffle portion of the intermediate chamber, the baffle portion being arranged to divide the flow of gas between first and second flowpaths. The first and second intermediate chamber outlet apertures may be provided in the respective flowpaths. The injector may be arranged wherein the first and second flowpaths converge within the delivery manifold.

Embodiments of the present invention are suitable for injecting precursor gas for depositing material on substrates of a range of different sizes. For example, a deposition system may be sized for deposition on substrates such as a single 1 inch (0.0254m) diameter wafer, 2 inch (0.0508m) diameter wafer or any other suitable size or number of wafers, such as 12 inch (0.305m) diameter wafers. A system may be sized for deposition on square/rectangular wafers of width 1m or any other suitable size or shape. Material may be deposited on a substrate in a continuous manner, for example on a sheet of material that moves past one or more injectors, forming the deposition region of the system, also named roll-to-roll or reel-to-reel; or by moving the injector over the surface on which deposition of material is required.

Advantageously, in some embodiments a gap between the injector and a plane of a surface of a substrate on which deposition takes place is kept substantially constant. This may be useful in enhancing containment of deposition gas and/or enhancing uniformity of deposition of material on the substrate.

Some embodiments of the present invention may be used to grow layers of a variety of different materials including GaAs, CdTe, ZnS, Copper indium gallium selenide (CulnxGa1-xSe2 or CIGS). Layers, islands, nanocrystals and/or other structures formed from these and other materials may be grown in some embodiments.

Examples of gaseous precursors that may be used in some embodiments include trimethyl gallium (TMG), trimethyl aluminium (TMA), trimethyl indium (TMI), phosphine, arsine, dimethethyl cadmium (DMCd), dimethyl selenide (DMSe) and dimethyl zinc (DMZ). Other gaseous precursors are known and may be used in embodiments of the present invention.

Within the scope of this application it is envisaged that the various aspects, embodiments, examples, features and alternatives set out in the preceding paragraphs, in the claims and/or in the following description and drawings may be taken independently or in any combination. Features described with reference to one embodiment are applicable to all embodiments, unless there is incompatibility of features.

For the avoidance of doubt, it is to be understood that features described with respect to one aspect of the invention may be included within any other aspect of the invention, alone or in appropriate combination with one or more other features.

### BRIEF DESCRIPTION OF THE DRAWINGS

Embodiments of the invention will now be described with reference to the accompanying figures in which:
FIGURE 1 is a cross-sectional view of an injector according to an embodiment of the present invention as viewed parallel to a z-axis, normal to axes x, y thereof;
FIGURE 2 is a cross-sectional view of the injector of FIG. 1 as viewed along line B-B parallel to the x-axis;
FIGURE 3 shows (a) a removable aperture element according to an embodiment of the present invention, (b) a removable aperture element according to a further embodiment of the present invention and (c) an injector according to a further embodiment of the present invention;
FIGURE 4 is an enlarged view of a portion of a delivery manifold of the injector as viewed along the x-axis;
FIGURE 5 is a cross-sectional view of a portion of a material deposition system as viewed along the x-axis showing a location of a delivery slit aperture;
FIGURE 6 is a view of an underside of the coating head shown in FIGURE 4 as viewed from the substrate platen; and
FIGURE 7 shows (a) an underside of an injector according to an embodiment of the invention and (b) an underside of a coating head according to an embodiment of the present invention.

### DETAILED DESCRIPTION

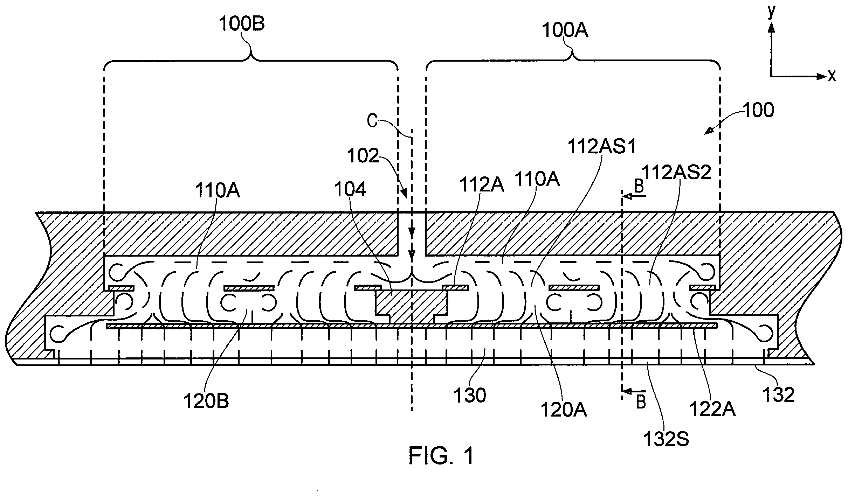

Embodiments of the present invention are directed to providing an injector for injecting gas into a material deposition system. FIG. 1 is a cross-sectional view of an injector 100 according to an embodiment of the present invention. The injector 100 is shown as viewed parallel to a z-axis thereof, normal to axes x and y. Axes x, y and z are substantially orthogonal to one another.

The injector has an inlet port 102 that may be connected to a source of gas to be injected by the injector 100. Gas enters the injector 100 through the inlet port 102 along a direction parallel to a 'vertical' axis y of the injector which is coincident with a cylinder axis C of the port 102. It is to be understood that reference to the vertical axis is reference to an axis normal to longitudinal and lateral axes x, z respectively and is not to be understood to be limiting with regard to an in-use orientation of the injector 100. It is to be understood that in some embodiments the injector may be used in any desired orientation such that the vertical axis y thereof is arranged parallel to a true vertical reference axis (e.g. with respect to earth), parallel to a true horizontal reference axis, or in any other required orientation.

Gas entering the injector 100 through the inlet port 102 impinges upon a diffuser member 104. The flow of gas is deflected in opposite directions parallel to the longitudinal axis x into either a first portion 100A of the injector 100 or a second portion 100B. The first and second portions 100A, 100B are substantially symmetrical about a mirror plane normal to the longitudinal axis x through cylinder axis C.

The arrangement of the first portion 100A of the injector 100 will now be described in detail. It is to be understood that the description is equally applicable to the second portion 100B which is constructed and functions in a similar manner.

Gas entering the first portion 100A enters the distribution chamber 110A of the first portion 100A. The flow of gas into and through the distribution chamber 110A in use is at a flow rate resulting in turbulent flow. In the case that the gas is a mixture of more than one type of gaseous molecule, the turbulent flow promotes mixing, increasing a homogeneity of the gas composition. The gas fills the distribution chamber 110A and passes through first and second slit apertures 112AS1, 112AS2 into an intermediate chamber 120A. The first and second slit apertures 112AS1, 112AS2 are provided in a distribution chamber aperture plate 112A that divides the distribution chamber 110A from the intermediate chamber 120A. The aperture plate 112A is arranged to be removable in some embodiments, allowing plates with different sizes of aperture to be employed depending on a user's requirements.

In the embodiment of FIG. 1, the first and second slit apertures 112AS1, 112AS2 are each formed by a single elongate aperture or hole in the aperture plate 112A. In some alternative embodiments, the slit apertures 112AS1, 112AS2 are provided by a plurality of sub-apertures (smaller sized apertures) or perforations defining a shape similar to that of the single aperture slit apertures 112AS1, 112AS2. The sub-apertures may be arranged in one or more rows, for example one or more rows of substantially circular apertures.

The forcing of gas through the slit apertures 112AS1, 112AS2 may force the gas to flow in a substantially laminar flow fashion when entering the intermediate chamber 120A.

It is to be understood that a pressure drop takes place as the gas flows from the inlet port 102 into the distribution chamber 110A, as the gas experiences sudden expansion. In some embodiments the flowpath of gas may be arranged wherein gas passing through the inlet port 102 is close to the pressure of the injector, dropping by up to 1% in the distribution chamber 110A. It is to be understood that the percentage drop may depend on the initial flow condition of the gas at the inlet port 102 and the dimensions of apertures 112AS1 and 112AS2. Under typical operating conditions it is envisaged that the reaction region will be at a pressure close to that of the surrounding environment, which is expected normally to be around 1 bar (100kPa).

It is to be understood that a drop in pressure will typically take place within the distribution chamber 110A as a function of distance from the inlet port 102 in the longitudinal direction. If a single slit aperture is provided in the distribution chamber aperture plate 112A a flow rate of gas through the aperture may decrease substantially as a function of distance along the aperture from the inlet port 102, resulting in nonuniform laminar flow of gas delivered through to the intermediate chamber 120A with respect to the longitudinal direction. This problem may be mitigated in some embodiments by varying a width of the aperture along the longitudinal direction, the aperture being narrower closer to the inlet port 102.

In some arrangements a plurality of substantially co-linear apertures are provided of different respective lengths. An aperture closer to the inlet port may be of a smaller area than an aperture further from the inlet port, thereby to encourage more uniform flow of gas into the intermediate chamber 120A along a length of the distribution chamber 110A.

In the embodiment of FIG. 1 the distribution chamber 110A is designed to promote a uniform distribution of gas flow rate through the intermediate chamber 120A by providing first and second slit apertures 112AS1, 112AS2, the first slit aperture 112AS1 being arranged to be shorter in length than the second slit aperture 112AS2 for the reasons described above.

In one example injector 100, to cover a width of around 150 mm, the injector 100 may have a length of around 150 mm and a height of around 30 mm. A combined length of the internal regions of portions 100A and 100B may be around 145 mm in this example. A distance from an inlet 102 to the outlet slit aperture 132S may be around 22 mm, and the inlet port 102 may have an area of around 12.5 square mm for gas flow therethrough. The outlet slit apertures 132S may have a combined area of around 89 square mm. Other dimensions are also useful.

Two or more injectors may be placed side by side and/or end to end. In such cases, two inlet ports may be provide in some embodiments.

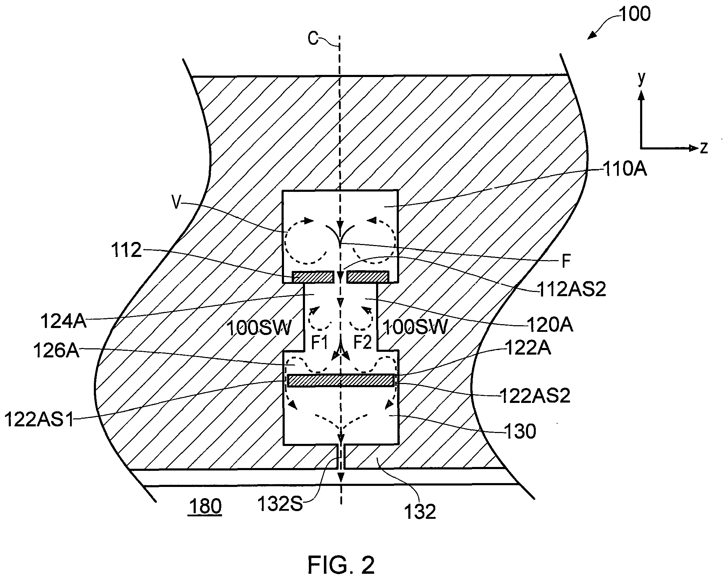

FIG. 2 is a cross-sectional view of the injector 100 along line B-B of FIG. 1 showing a flowpath F of gas from the distribution chamber 110A through the injector 100. As can be seen from FIG. 2 the injector 100 is substantially symmetrical about a plane normal to lateral axis z and passing through the cylinder axis C of the inlet port 102 (the position of the cylinder axis C being superimposed on FIG. 2 for clarity).

Gas entering the intermediate chamber 120A flows through a first portion 124A of the intermediate chamber 120A and subsequently through a second portion 126A. The first portion 124A is of a narrower lateral width (parallel to the z-axis) compared with the width of the distribution chamber 110A and may be referred to as a throat portion. Some flow vortices may form in the intermediate chamber 120A however they are typically smaller in diameter than those that form in the distribution chamber 120A.

The second portion 126A of the intermediate chamber 120A is of greater lateral width than the first portion 124A, the width of the intermediate chamber 120A increasing relatively abruptly at the boundary between the first and second portions 124A, 126A. In some alternative embodiments the increase may be more gradual. Gas flowing through the second portion 126A is deflected laterally by an intermediate chamber aperture plate 122A, towards a respective first or second intermediate chamber slit aperture 122AS1, 122AS2. The first and second intermediate chamber slit apertures 122AS1, 122AS2 are defined by a gap between the intermediate chamber aperture plate 122A and sidewalls 100SW of the injector 100, the apertures 122AS1, 122AS2 being displaced laterally outward of the portions of the sidewalls 100SW defining the throat portion 124A of the intermediate chamber 120A.

Gas flowing out from the intermediate chambers 120A, 120B of the first and second portions 100A, 100B of the injector 100 enters a common delivery manifold 130 having a lateral width substantially equal to that of the second portion 126A of the intermediate chamber 120A. Flow of gas through the delivery manifold 130 converges towards an elongate delivery slit aperture 132S formed in a lower wall 132 of the delivery manifold 130 with respect to the orientation shown in FIG. 2.

Thus, the flowpath of gas through the injector 100 is split along first and second flow paths F1, F2 from the intermediate chamber 120 to the delivery manifold 130 followed by recombination of the flow paths F1, F2 in the delivery manifold 130. This has been found to further promote a more uniform gas velocity distribution along the delivery slit aperture 132S.

It is to be understood that the injector 100 is arranged to be substantially symmetrical about the plane normal to the lateral axis z and coincident with cylinder axis C so as to promote symmetry in the flowpath of gas through the injector 100. The results of fluid dynamics simulations indicate that such an arrangement promotes enhanced uniformity of gas velocity along the gas delivery slit aperture 132S.

Embodiments of the invention advantageously provide an injector that is able to enhance mixing of gases in the distribution chamber by establishing turbulent flow therein, before re-establishing laminar flow at the elongate outlet slit aperture 132S of the delivery manifold. Exceptional uniformity of flow velocity as a function of distance along the slit aperture may be established. This feature promotes uniformity of gas flow across a substrate platen or other substrate support surface. This can enhance uniformity of composition and thickness of material deposited on the substrate by reaction of one or more precursor gases. Furthermore, shield gas curtains of exceptional performance may be established. The high uniformity of shield gas flow reduces considerably leakage of precursor gas beyond the curtain. It also prevents ingress of gases in the opposite direction, reducing a risk of contamination of growing materials. For example, a risk that oxygen, water vapour or other contaminants penetrate the region shielded by shield gas is greatly reduced.

In the embodiment of FIG. 1 the delivery manifold outlet slit aperture 132S is arranged to direct a flow of gas through the injector in a direction substantially parallel to the vertical axis y.

In some alternative embodiments the outlet aperture is arranged to direct the flow of gas at an angle to the vertical. This may be useful in promoting laminar flow of gas over a surface of a substrate since the gas molecules emerge from the injector with a component of velocity parallel to the plane of the substrate. This reduces the amount of the required change in momentum of the gas molecules upon collision with the surface. Promoting laminar flow over the surface of the substrate may increase the amount of time during which the gas is in close proximity to the surface, increasing the likelihood of deposition of material on the surface in the case that the gas is being employed to deposit material.

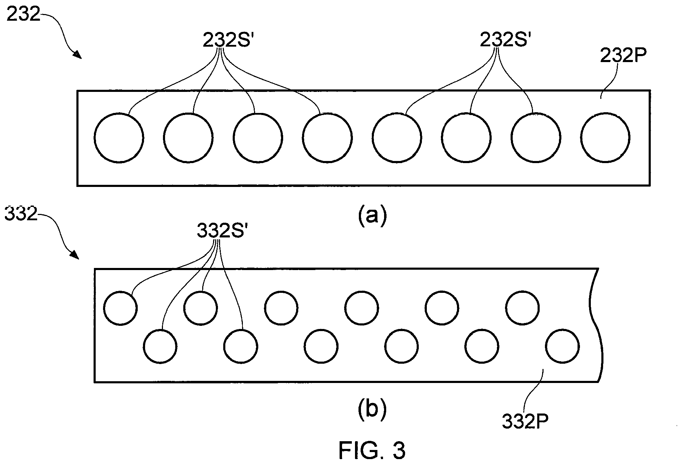

FIG. 3(a) is a schematic illustrate of a gas delivery aperture 232 according to an alternative embodiment. Instead of a single elongate slit aperture 132S, the gas delivery aperture 232 is composed of a plurality of substantially circular apertures or sub-apertures 232S' that collectively define a substantially elongate delivery aperture 232. In the arrangement of FIG. 3(a) the delivery aperture 232 is provided by eight sub-apertures 232S' arranged in a substantially straight line. In the arrangement of FIG. 3(b) a delivery aperture 332 is provided by two substantially straight lines of six sub-apertures 332S', the two lines of sub-apertures 332S' being staggered in the arrangement shown. Other arrangements are also useful. Other numbers and arrangements or apertures are also useful. The sub-apertures may be referred to as perforations.

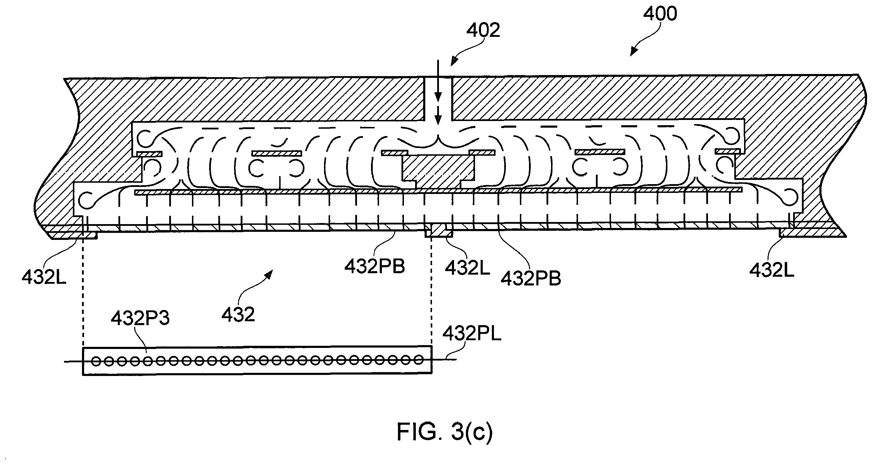

In the arrangements shown in FIG. 3 the delivery aperture 232S and the delivery aperture 332S are formed in a respective delivery aperture plate 232P, 332P. The delivery apertures 232S, 332S are formed by drilling through the plate in the embodiment shown although other methods of forming the apertures 232S, 332S are also useful. The delivery aperture plates 232P, 332P are arranged to be removably fitted to an injector according to an embodiment of the present invention. The provision of an injector having a removeable delivery aperture plate allows replacement of the aperture plate when required to allow cleaning and general maintentance of the injector, as well as to allow

FIG. 3(c) is a cross-sectional illustration of an injector 400 according to an embodiment of the invention. The view of FIG. 3(c) corresponds to that of FIG. 1 and in FIG. 3(c) like features to those of the embodiment of FIG. 1 are shown with like reference signs incremented by 300. The injector 400 if FIG. 3(c) has a delivery aperture 432 that is defined by two removable aperture bodies, elements or plates 432PB, 432PA disposed end to end, with their longitudinal axes 432PL disposed in a substantially co-linear arrangement. Each aperture element 432PB, 432PA has a row of substantially circular sub-apertures 432S' formed therein. A plan view of one aperture element432PB is shown below the injector 400 for ease of understanding. The aperture elements 432A, 432B are held in place by means of a lip 432L formed in a housing of the injector 400. The elements 432A, 432B rest upon the lip 432L. In some embodiments the elements 432A, 432B may be held in place by one or more fixing elements such as one or more clips, screws, bolts or the like. Other arrangements are also useful. The aperture elements 432PB, 432PA may be described as perforated or foraminate. In the embodiment shown the elements 432PB, 432PA are substantially plate-like, although other arrangements are also useful.

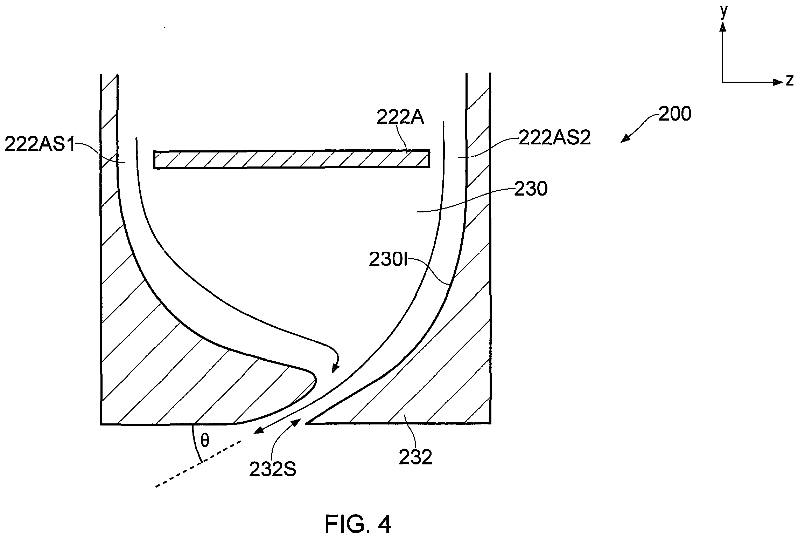

FIG. 4 shows an example of the bottom section from an injector 200 arranged to direct a blade of gas emerging from elongate delivery slit aperture 232S at a non-zero angle to the y axis. It can be seen that opposed walls of the internal surface 2301 of the delivery manifold 230 curve toward the gas delivery slit aperture 232S from the first and second intermediate chamber slit apertures 222AS1, 222AS2 as a function of distance along the y axis. The lower wall 232 of the delivery manifold 230 is shaped to define a channel at an angle θ (theta) to the lateral z axis. In the embodiment shown, θ is around 30°. Other angles are however also useful such as 10°, 20°, 45°, 60° or any other suitable angle. It is to be understood that gas flowing through the first and second intermediate chamber slit apertures 222AS1, 222AS2 tends to follow a flowpath that runs close to and parallel to the internal surface 230I of the delivery manifold 230 according to the Coand 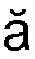 effect. The feature that the internal surface 230I is curved exploits the Coand 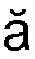 effect to bend the flow along the internal surface 230I in the delivery manifold 230 and promote stable flow of gas with substantially uniform velocity as a function of position and shape along the gas delivery slit aperture 232S.

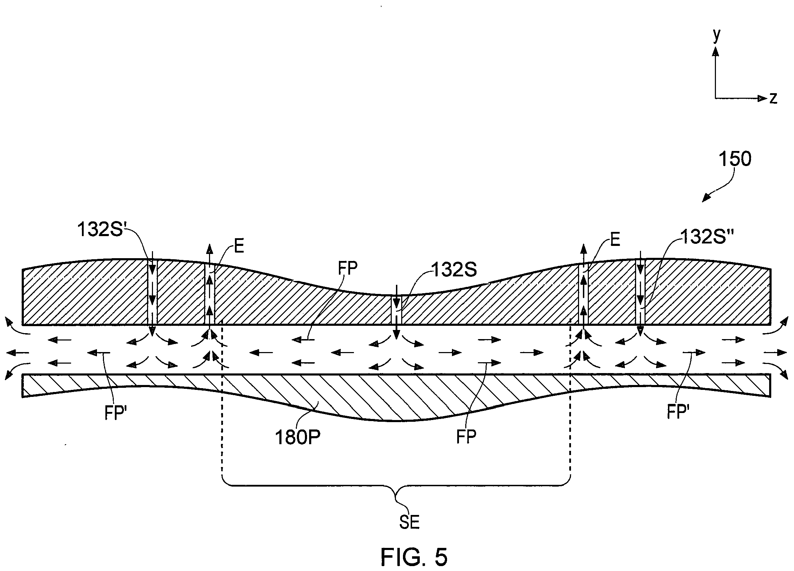

FIG. 5 is a cross-sectional view of a coating head portion 150 of a deposition system showing delivery manifold outlet slit apertures 132S, 132S', 132S" of three injectors (not shown) according to the embodiment of FIG. 1. The coating head portion 150 is shown position above a substrate platen 180P.

One of the injectors is arranged to inject precursor gases through outlet slit aperture 132S in a central region of the substrate platen 180P whilst the remaining two injectors are arranged to inject shield gas through outlet slit apertures 132S', 132S" at peripheral regions of the substrate platen 180P. Exhaust ports E are located inboard of the outlet slit apertures 132S', 132S", for extracting precursor gases and shield gas.

In use, a flow of shield gas is established through each of outlet slit apertures 132S', 132S" in the form of a substantially uniform blade of gas. A flow of precursor gases is established through outlet slit aperture 132S. Extraction of injected gas takes place via exhaust ports E. Gas emerging from outlet slit aperture 132S is deflected laterally by the substrate platen 180P in one of two opposite directions towards a respective exhaust port E. A flow of precursor gas from outlet slit aperture 132S substantially parallel to the platen 180P is thereby established. Shield gas injected by outlet slit apertures 132S', 132S" is also deflected laterally by the substrate platen 180P in two opposite directions, towards and away from the respective exhaust port E. Shield gas deflected towards the respective exhaust port E is extracted via the exhaust port E together with any unreacted precursor gas and any reaction products that may be generated through deposition of material on a substrate placed on the platen 180P.

It is to be understood that embodiments of the present invention find application in a range of different material deposition technologies. In some applications, the injector may be used to deposit GaAs on a substrate. Precursor gases such as trimethyl gallium (TMG) and tertiarybutylarsine (TBA) or a mixture thereof may be injected by means of one or more injectors for reaction at the substrate. Other gases may also be used for the deposition of other materials including other III-V compounds, II-VI compounds or any other suitable materials.

In some embodiments, injectors may be arranged so as to grow multilayer structures, such as structures having alternating layers of respective materials, or layers with different respective dopant concentrations and/or dopant types. Thus in some embodiments device structures such as diode device structures may be fabricated.

Other arrangements are also useful. In some embodiments, one or more layers may be deposited that are subsequently heated to react with one or more other materials, for example in the fabrication of copper based chalcogenides for applications including solar cell devices. For example, a copper/indium/gallium structure may be fabricated sequentially and subsequently selenised by heating in a selenium-bearing atmosphere to form a copper indium gallium diselenide (CIGS) structure. Embodiments of the present invention are well suited to such a process because the structure can be grown within the same inline system without necessarily moving the substrate from one environment to another. Thus the deposition system may be operated as a batch deposition system, or batch reactor.

Other materials such as functional oxides may be fabricated, for example fluoride doped tin oxide (SnO₂:F) or aluminium doped zinc oxide (ZnO:AI). Cadmium telluride (CdTe) solar cell structures may also be fabricated using the apparatus described herein, using precursors such as dimethylcadmium (DMCd) and diisopropyltelluride (DIPTe).

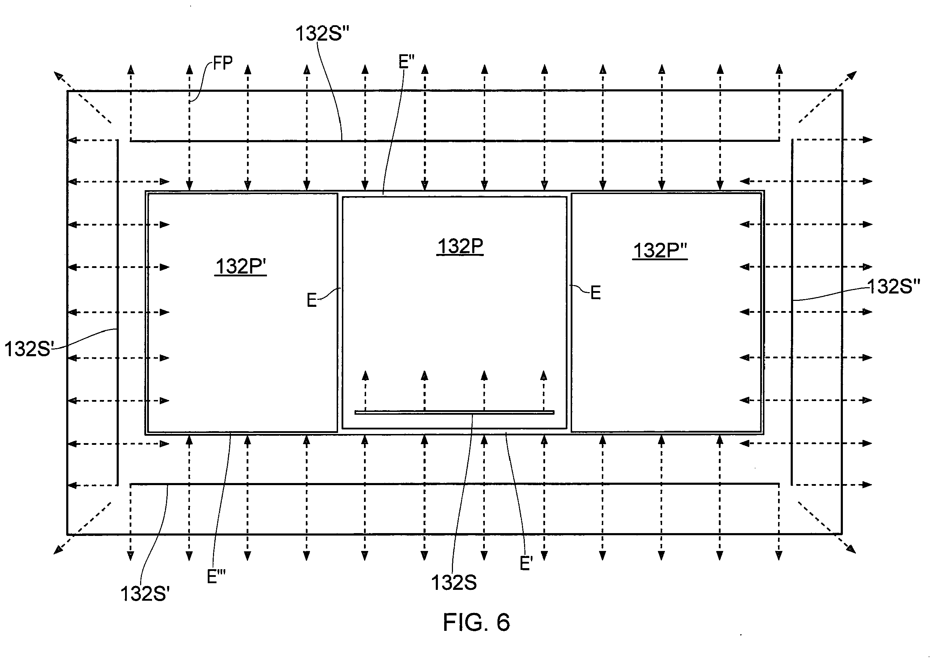

FIG. 6 is a view of an underside of the coating head portion 150 of the apparatus shown in FIG. 5 as viewed from the substrate platen 180P. The head portion 150 is arranged to define a substrate exposure region SE (FIG. 5) above the platen 180P in which a substrate may be exposed to precursor gas (which may be a mixture of gases) injected through a delivery manifold outlet slit aperture 132S of a precursor gas injector 100 (of which only the slit aperture 132S is shown). The substrate exposure region SE is defined substantially by the location of an exhaust aperture E which forms a substantially continuous slit aperture around injector plate 132P which supports precursor injector 100 above the platen 180P. The exhaust aperture E is in fluid communication with an extraction device (not shown) such as a fan and adequate filtering system for extracting precursor gas from the substrate exposure region SE.

In the arrangement shown in FIG. 6 the slit aperture 132S is disposed closer to the portion E' of the exhaust aperture E defining one edge of the substrate exposure region SE than the portion E" at the opposite edge of the exposure region, rather than being located substantially midway between the two as in the arrangement of FIG. 5. This results in longer resident time of the precursor gases and may be preferred promoting more uniform lateral flow of precursor gas over a substrate located in a central portion of the substrate exposure region SE. Flow of gas over a substrate is promoted by unbalancing the extraction flows between portion E' and E" of the exhaust aperture, by increasing flow through E" being on the opposite side of the substrate exposure region to the slit aperture 132S, relative to the remainder of the aperture E. This is accomplished in the embodiment shown by increasing a width of the exhaust aperture E in the region defined by portion E". Other arrangements are also useful.

In the arrangement shown in FIG. 6, two further blank injector plates 132P', 132P" are provided on opposite sides of the first injector plate 132P. The plates 132P, 132P', 132P" are removable to allow insertion of a larger plate accommodating an injector having a larger outlet aperture 132S. Alternatively further plates supporting an injector similar to plate 132P can be substituted for one or both of the blank injector plates 132P', 132P". In some embodiments the exhaust aperture E may have portions E'" around the further injector plates 132P', 132P".

Four further injectors 100 are arranged to border the injector plates 132P, 132P', 132P" so as to enable a curtain of inert 'curtain' gas such as nitrogen or any other suitable gas to be provided around the exhaust aperture E. Delivery manifold outlet slit apertures 132S', 132S" of these injectors 100 are shown in FIG. 6. Arrows FP illustrate a flowpath of gas injected through the apertures 132S', 132S". It can be seen that some of the curtain gas is drawn in an inboard direction towards the exhaust aperture E whilst some of the curtain gas flows in an outboard direction away from the exhaust aperture E.

In use, the flow rates of curtain gas and precursor gas and an exhaust pressure applied to the exhaust aperture E may be adjusted in order to balance gas flow and promote the exhaust of unreacted precursor gas and any gaseous reaction products through the exhaust aperture E. The flow of curtain gas towards the exhaust aperture E reduces a likelihood that precursor gas escapes from the substrate exposure region. Furthermore, the flow of curtain gas in the outboard direction reduces a likelihood that atmospheric gases present beyond the curtain of gas flows towards the substrate exposure region SE. This reduces contamination of material deposited by the coating head portion 150 on a substrate.

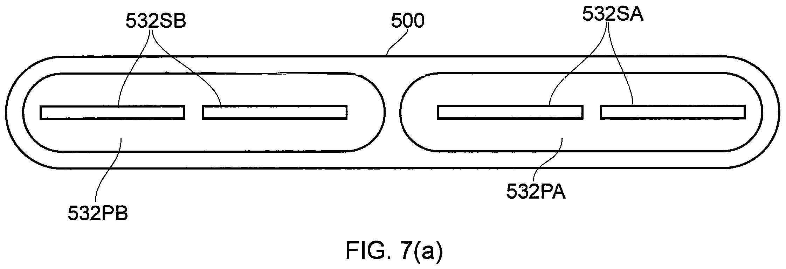

FIG. 7(a) shows an underside of an injector 500 according to an embodiment of the present invention. The injector 500 is similar to the injector 400 of FIG. 3(c) except that the aperture elements 532PA, 532PB each have two apertures in the form of elongate slits 532SA, 532SB, respectively, formed therethrough.

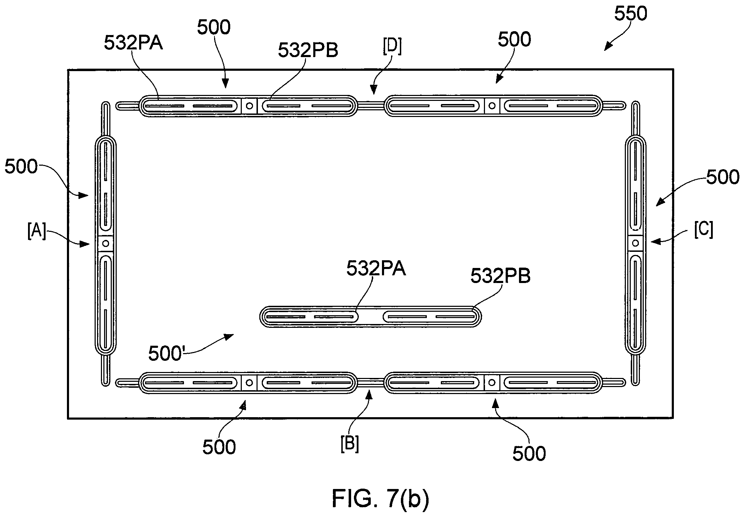

FIG. 7(b) 5 is a view of an underside of a coating head portion 550 of an apparatus similar to that shown in in FIG. 5 as viewed from immediately below the coating head portion 550. The coating head portion 550 has six injectors 500 arranged to inject inert gas, in the present embodiment nitrogen gas, so as to define a curtain around a substrate exposure region in which a substrate is exposed to precursor gas.

A further injector 500', being a precursor gas injector 500', is disposed within the region bounded by the six inert gas injectors 500. The precursor gas injector 500' is configured to inject a precursor gas mixture over a substrate disposed on a substrate platen in a similar manner to the precursor gas injector 100 of the embodiment of FIG. 6.

Embodiments of the present invention are suitable for use in atmospheric pressure systems in which the pressure of gas in the substrate exposure region SE is around atmospheric pressure. In some embodiments it is not necessary to provide a gas tight barrier between the coating head and atmosphere. This is because the coating head 150 is able to prevent atmospheric gases from entering the deposition region. Furthermore, in some embodiments the coating head substantially prevents flow of precursor gases beyond the curtain of inert gas, thereby preventing escape of precursor gases to atmosphere. In some embodiments a human operator can safely work outboard of the curtain of inert gas with no gas tight barrier between the operator and curtain.

The embodiments allows for operation under different pressure (not only atmospheric pressure) of the surrounding environments to be used via control of the flow of exhaust gases in accordance with a required differential pressure between the reaction region SE and the pressure in the surrounding environment.

Other arrangements are also useful. Embodiments of the invention provide a remarkable improvement in performance of a gas injector by providing an injector capable of generating a blade of gas having a uniform, stable flow of gas at an elongate delivery aperture thereof. Thus, a density of gas and a velocity of gas flow out from the delivery aperture is substantially constant along a length of the aperture in some embodiments. This facilitates an increase in uniformity of composition and thickness of materials grown using such an injector. It also facilitates in some embodiments the provision of a gas curtain capable of substantially preventing flow of precursor gases therepast.

Reference to a deposition system is to be understood to include reference to a growth system, since growth of a material on a substrate by passage of a gaseous precursor thereover involves deposition of material on the surface. Deposition/growth may occur by reaction of the precursor gas, e.g. between respective gaseous species, and/or between one or more gaseous precursor species and the substrate. Other arrangements are also useful. Reaction may take place at or close to the substrate surface, for example due to heating of the substrate, heating of the deposition region, the presence of radiation such as radio frequency radiation, and/or any other suitable means.

Throughout the description and claims of this specification, the words "comprise" and "contain" and variations of the words, for example "comprising" and "comprises", means "including but not limited to", and is not intended to (and does not) exclude other moieties, additives, components, integers or steps.

Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics, compounds, chemical moieties or groups described in conjunction with a particular aspect, embodiment or example of the invention are to be understood to be applicable to any other aspect, embodiment or example described herein unless incompatible therewith.

## Claims

1. An injector (100) for injecting a gas in a material deposition system, the injector (100) comprising:
a gas inlet port (102) for coupling the injector to a gas source;
a distribution chamber (110A), an intermediate chamber (120A) and a delivery manifold (130) arranged in series to provide a flowpath for the gas between the inlet port (102) and at least one delivery aperture (132S) through which the gas is injectable in the deposition system,
the injector (100) having at least a first distribution chamber outlet aperture (112AS1, 112AS2) through which gas may flow from the distribution chamber (110A) to the intermediate chamber (120A) and at least first and second intermediate chamber outlet apertures (122AS1, 122AS2) through which gas may flow from the intermediate chamber (120A) to the delivery manifold (130),
the intermediate chamber (120A) being arranged to divide a flow of gas therethrough between first and second flowpaths (F1, F2), the first and second intermediate chamber outlet apertures (122AS1, 122AS2) being provided in the respective first and second flowpaths (F1, F2), the injector (100) being arranged to allow the first and second flowpaths (F1, F2) to converge within the delivery manifold (130),
wherein each one of the distribution chamber aperture (112AS1, 112AS2), intermediate chamber aperture (122AS1, 122AS2) and delivery manifold aperture (132S) is elongate in shape,
wherein the first distribution chamber outlet aperture (112AS1, 112AS2) has a longitudinal axis disposed substantially parallel to an x-axis of the injector,
wherein the first and second intermediate chamber outlet apertures (122AS1, 122AS2) each have a longitudinal axis disposed substantially parallel to the x-axis of the injector (100), and
wherein longitudinal axes of the first substantially elongate distribution chamber outlet aperture (112AS1, 112AS2) and the first and second elongate intermediate chamber outlet apertures (122AS1, 122AS2) define the apices of an equilateral triangle as viewed along a direction parallel to the x-axis.

2. An injector (100) as claimed in any preceding claim arranged wherein the flow of gas, in use, through the intermediate chamber (120A) is divided substantially equally between the first and second flowpaths (F1, F2).

3. An injector (100) as claimed in any preceding claim wherein the flow of gas, in use, through the intermediate chamber (120A) is divided between the first and second flowpaths (F1, F2) by baffle means (122A).

4. An injector (100) according to claim 3 wherein the baffle means (122A) is provided by a wall of the intermediate chamber (120A) disposed between the first and second intermediate chamber outlet apertures (122AS1, 122AS2) and dividing the intermediate chamber (120A) from the delivery manifold (130).

5. An injector (100) as claimed in any preceding claim arranged wherein a distribution chamber aperture plate (112A) is provided between the distribution chamber (110A) and intermediate chamber (120A, 120B), the distribution chamber aperture plate (112A) having the first distribution chamber outlet aperture (112AS1, 112AS2) provided therein.

6. An injector as claimed in any preceding claim wherein the distribution chamber (110A), intermediate chamber (120A) and delivery manifold (130) each have substantially parallel longitudinal axes, optionally wherein the longitudinal axes of the distribution chamber (110A), intermediate chamber (120A) and delivery manifold (130) are substantially parallel to the x-axis of the injector (100).

7. An injector (100) as claimed in any preceding claim wherein the injector (100) comprises a plurality of distribution chamber outlet apertures (112AS1, 112AS2) provided at spaced apart locations, wherein, optionally:
the plurality of distribution chamber outlet apertures (112AS1, 112AS2) are substantially collinear; and/or
a length of each distribution chamber outlet aperture (112AS1, 112AS2) decreases as a function of distance from the inlet port (102).

8. An injector (100) as claimed in any preceding claim comprising first and second respective portions (100A, 100B), wherein:
the first and second portions have a respective distribution chamber (110A) or share a common distribution chamber (110A);
the first and second portions each have a respective intermediate chamber (120A, 120B); and
the first and second portions have a respective delivery manifold (130) or share a common delivery manifold (130),
each portion further comprising at least one distribution chamber outlet aperture (112AS1, 112AS2) and at least first and second elongate intermediate chamber outlet apertures (122AS1, 122AS2), wherein gas, in use, entering the injector (100) through the gas inlet port (102) is divided between the distribution chambers (110A) of the first and second portions (100A, 100B).

9. An injector (100) as claimed in claim 8:
wherein the first and second portions (100A, 100B) share a common longitudinal axis, and/or
wherein the respective intermediate chambers (120A, 120B) are separated from one another by barrier means (104), and/or
wherein the first and second portions (100A, 100B) share a common distribution chamber (110A), and/or
wherein the first and second portions share a common delivery manifold (130), and/or
wherein the first and second portions share a common delivery aperture (132S), and/or
wherein the first and second portions share a common inlet port (102), and/or
wherein the injector (100) is arranged to be substantially symmetrical about a plane normal to a longitudinal axis thereof between the first and second portions (100A, 100B).

10. An injector (100) as claimed in any preceding claim wherein at least one of the apertures (232) comprises a plurality of sub-apertures (232S'), optionally wherein the plurality of sub-apertures (232S') are substantially circular.

11. A materials deposition system comprising a deposition region in which deposition of material takes place on a substrate and at least one injector (100) as claimed in any preceding claim.

12. A system as claimed in claim 11 comprising at least one injector (100) arranged to inject deposition gas, in use, into the deposition region, the deposition gas comprising material to be deposited on a substrate.

13. A method of injecting gas in a materials deposition system by means of an injector (100), comprising:
establishing a flow of gas through the injector (100) from a gas inlet (102) to a elongated delivery aperture (132S) thereof whereby the gas flows through a distribution chamber (110A), an intermediate chamber (120A, 120B) and a delivery manifold (130) coupled in series,
the method comprising allowing the gas to expand within the distribution chamber (110A) and to pass through at least a first distribution chamber outlet aperture (112AS1, 112AS2) into the intermediate chamber (120A), the flow of gas being arranged to flow along one of a first and a second flowpath (F1, F2) through a first or a second intermediate chamber outlet aperture (122AS1, 122AS2) provided in the first and second flowpaths (F1, F2) respectively,
the method comprising allowing the first and second flowpaths (F1, F2) to converge within the delivery manifold (130), wherein the method further comprises:
providing the first distribution chamber outlet aperture (112AS1, 112AS2) whereby the aperture (112AS1, 112AS2) has a longitudinal axis disposed substantially parallel to an x-axis of the injector (100);
providing the first and second intermediate chamber outlet apertures (122AS1, 122AS2) whereby each has a longitudinal axis disposed substantially parallel to the x-axis of the injector (100); and
providing the first substantially elongate distribution chamber outlet aperture (112AS1, 112AS2) and the first and second elongate intermediate chamber outlet apertures (122AS1, 122AS2) such that longitudinal axes thereof define the apices of an equilateral triangle as viewed along a direction parallel to the x-axis.

14. A method according to claim 13:
whereby establishing the flow of gas through a distribution chamber (110A), an intermediate chamber (120A, 120B) and a delivery manifold (130) comprises establishing the flow of gas through a substantially elongate distribution chamber (110A), a substantially elongate intermediate chamber (120A, 120B) and a substantially elongate delivery manifold (130); and/or
whereby establishing a flow of gas through the injector (100) from a gas inlet (102) to a delivery aperture (132S) comprises establishing a flow of gas through the injector (100) from a gas inlet (102) to an elongate delivery aperture (132S) and allowing a gas to pass through at least a first distribution chamber outlet aperture (112AS1, 112AS2) comprises allowing a gas to pass through at least a first substantially elongate distribution chamber outlet aperture (112AS1, 112AS2); and/or
comprising causing the flow of gas in use through the intermediate chamber (120A, 120B) to be divided substantially equally between the first and second flowpaths (F1, F2); and/or
comprising causing the flow of gas through the intermediate chamber (120A, 120B) to be divided between the first and second flowpaths (F1, F2) by baffle means (122A), optionally comprising providing the baffle means (122A) in the form of a wall of the intermediate chamber disposed between the first and second intermediate chamber outlet apertures (122A, 122B) and dividing the intermediate chamber (120A, 120B) from the delivery manifold (130); and/or
comprising causing the gas to flow through a first distribution chamber outlet aperture (112AS1, 112AS2) provided in a distribution chamber aperture plate (112A), the distribution chamber aperture plate (112A) being provided between the distribution chamber (110A) and intermediate chamber (120A, 120B); and/or
comprising providing the distribution chamber (110A), intermediate chamber (120A, 120B) and delivery manifold (130) such that they have substantially parallel longitudinal axes, wherein optionally the distribution chamber (110A), intermediate chamber (120A, 120B) and delivery manifold (130) are arranged such that their longitudinal axes are substantially parallel to the x-axis of the injector (110).

15. A method according to any one of claims 13 or 14 comprising providing a plurality of distribution chamber outlet apertures (112AS1, 112AS2) at spaced apart locations, wherein optionally the plurality of distribution chamber outlet apertures (112AS1, 112AS2) are substantially collinear.

## Patentansprüche

1. Injektor (100) zum Injizieren eines Gases in ein Materialauftragssystem, wobei der Injektor (100) Folgendes umfasst:
einen Gaseinlassanschluss (102) zum Koppeln des Injektors mit einer Gasquelle;
eine Verteilungskammer (110A), eine Zwischenkammer (120A) und einen Abgabeverteiler (130), die in Serie angeordnet sind, um einen Strömungspfad für das Gas zwischen dem Einlassanschluss (102) und wenigstens einer Abgabeöffnung (132S) bereitzustellen, durch die das Gas in das Auftragssystem injiziert werden kann,
wobei der Injektor (100) wenigstens eine erste Verteilungskammerauslassöffnung (112AS1, 112AS2) hat, durch die Gas von der Verteilungskammer (110A) zur Zwischenkammer (120A) fließen kann, und wenigstens erste und zweite Zwischenkammerauslassöffnungen (122AS1, 122AS2), durch die Gas von der Zwischenkammer (120A) zum Abgabeverteiler (130) fließen kann,
wobei die Zwischenkammer (120A) zum Unterteilen eines Flusses von Gas durch sie zwischen dem ersten und zweiten Strömungspfad (F1, F2) ausgelegt ist, wobei die ersten und zweiten Zwischenkammerauslassöffnungen (122AS1, 122AS2) im jeweiligen ersten und zweiten Strömungspfad (F1, F2) vorgesehen sind, wobei der Injektor (100) so ausgelegt ist, dass er ein Konvergieren des ersten und zweiten Strömungspfades (F1, F2) im Abgabeverteiler (130) zulässt,
wobei jede aus erster Verteilungskammeröffnung (112AS1, 112AS2), Zwischenkammeröffhung (122AS1, 122AS2) und Abgabeverteileröffnung (132S) länglich geformt ist,
wobei die erste Verteilungskammerauslassöffnung (112AS1, 112AS2) eine Längsachse hat, die im Wesentlichen parallel zu einer x-Achse des Injektors angeordnet ist,
wobei die erste und zweite Zwischenkammerauslassöffnung (122AS1, 122AS2) jeweils eine Längsachse haben, die im Wesentlichen parallel zur x-Achse des Injektors (100) angeordnet ist, und
wobei Längsachsen der ersten im Wesentlichen länglichen Verteilungskammerauslassöffnung (112AS1, 112AS2) und der ersten und zweiten länglichen Zwischenkammerauslassöffnungen (122AS1, 122AS2) die Scheitelpunkte eines gleichseitigen Dreiecks in einer Richtung parallel zur x-Achse betrachtet definieren.

2. Injektor (100) nach einem vorherigen Anspruch, so ausgelegt, dass der Fluss des Gases beim Gebrauch von der Zwischenkammer (120A) im Wesentlichen gleichmäßig zwischen dem ersten und zweiten Strömungspfad (F1, F2) unterteilt wird.

3. Injektor (100) nach einem vorherigen Anspruch, wobei der Fluss von Gas beim Gebrauch durch die Zwischenkammer (120A) zwischen dem ersten und zweiten Strömungspfad (F1, F2) durch Ablenkmittel (122A) unterteilt wird.

4. Injektor (100) nach Anspruch 3, wobei das Ablenkmittel (122A) durch eine Wand der Zwischenkammer (120A) bereitgestellt wird, die zwischen der ersten und zweiten Zwischenkammerauslassöffhung (122AS1, 122AS2) angeordnet ist und die Zwischenkammer (120A) vom Abgabeverteiler (130) abtrennt.

5. Injektor (100) nach einem vorherigen Anspruch, wobei eine Verteilungskammeröffhungsplatte (112A) zwischen der Verteilungskammer (110A) und der Zwischenkammer (120A, 120B) vorgesehen ist, wobei in der Verteilungskammeröffhungsplatte (112A) die erste Verteilungskammerauslassöffnung (112AS1, 112AS2) vorgesehen ist.

6. Injektor nach einem vorherigen Anspruch, wobei die Verteilungskammer (110A), die Zwischenkammer (120A) und der Abgabeverteiler (130) jeweils im Wesentlichen parallele Längsachsen haben, wobei optional die Längsachsen der Verteilungskammer (110A), der Zwischenkammer (120A) und des Abgabeverteilers (130) im Wesentlichen parallel zur x-Achse des Injektors (100) sind.

7. Injektor (100) nach einem vorherigen Anspruch, wobei der Injektor (100) mehrere Verteilungskammerauslassöffnungen (112AS1, 112AS2) umfasst, die an beabstandeten Stellen vorgesehen sind, wobei optional:
die mehreren Verteilungskammerauslassöffnungen (112AS1, 112AS2) im Wesentlichen kollinear sind; und/oder
eine Länge jeder Verteilungskammerauslassöffnung (112AS1, 112AS2) in Abhängigkeit vom Abstand vom Einlassanschluss (102) abnimmt.

8. Injektor (100) nach einem vorherigen Anspruch, der erste und zweite jeweilige Abschnitte (100A, 100B) umfasst, wobei:
ein erster und zweiter Abschnitt eine jeweilige Verteilungskammer (110A) haben oder eine gemeinsame Verteilungskammer (110A) nutzen;
der erste und zweite Abschnitt jeweils eine jeweilige Zwischenkammer (120A, 120B) haben; und
der erste und zweite Abschnitt einen jeweiligen Abgabeverteiler (130) haben oder sich einen gemeinsamen Abgabeverteiler (130) teilen,
wobei jeder Abschnitt ferner wenigstens eine Verteilungskammerauslassöffnung (112AS1, 112AS2) und wenigstens erste und zweite längliche Zwischenkammerauslassöffnungen (122AS1, 122AS2) umfassen, wobei beim Gebrauch durch den Gaseinlassanschluss (102) in den Injektor (100) eintretendes Gas zwischen den Verteilungskammern (110A) des ersten und zweiten Abschnitts (100A, 100B) unterteilt wird.

9. Injektor (100) nach Anspruch 8:
wobei der erste und zweite Abschnitt (100A, 100B) eine gemeinsame Längsachse haben, und/oder
wobei die jeweiligen Zwischenkammern (120A, 120B) durch Sperrmittel (104) voneinander getrennt sind, und/oder
wobei sich der erste und zweite Abschnitt (100A, 100B) eine gemeinsame Verteilungskammer (110A) teilen, und/oder
wobei sich der erste und zweite Abschnitt einen gemeinsamen Abgabeverteiler (130) teilen, und/oder
wobei der erste und zweite Abschnitt eine gemeinsame Abgabeöffnung (132S) haben, und/oder
wobei der erste und zweite Abschnitt einen gemeinsamen Einlassanschluss (102) haben, und/oder
wobei der Injektor (100) im Wesentlichen symmetrisch um eine Ebene normal zu einer Längsachse davon zwischen dem ersten und zweiten Abschnitt (100A, 100B) ist.

10. Injektor (100) nach einem vorherigen Anspruch, wobei wenigstens eine der Öffnungen (232) mehrere Suböffnungen (232S') umfasst, wobei optional die mehreren Suböffhungen (232S') im Wesentlichen kreisförmig sind.

11. Materialauftragssystem, das eine Auftragsregion umfasst, in der das Ablegen von Material auf einem Substrat stattfindet, und wenigstens einen Injektor (100) nach einem vorherigen Anspruch.

12. System nach Anspruch 11, das wenigstens einen Injektor (100) umfasst, ausgelegt zum Injizieren von Auftragsgas, beim Gebrauch, in die Auftragsregion, wobei das Auftragsgas auf ein Substrat aufzutragendes Material umfasst.

13. Verfahren zum Injizieren von Gas in einem Materialauftragssystem mittels eines Injektors (100), das Folgendes beinhaltet:
Erzeugen eines Flusses von Gas durch den Injektor (100) von einem Gaseinlass (102) zu einer länglichen Abgabeöffnung (132S) davon, so dass das Gas durch eine Verteilungskammer (110A), eine Zwischenkammer (120A, 120B) und einen Abgabeverteiler (130), in Serie gekoppelt, fließt,
wobei das Verfahren das Zulassen des Expandierens des Gases in der Verteilungskammer (110A) und das Leiten durch wenigstens eine erste Verteilungskammerauslassöffhung (112AS1, 112AS2) in die Zwischenkammer (120A) beinhaltet, wobei der Fluss von Gas so ausgelegt ist, dass er entlang einem aus einem ersten und einem zweiten Strömungspfad (F1, F2) durch eine erste oder eine zweite Zwischenkammerauslassöffhung (122AS1, 122AS2) fließt, die jeweils im ersten bzw. zweiten Strömungspfad (F1, F2) vorgesehen ist,
wobei das Verfahren das Zulassen des Konvergierens des ersten und zweiten Strömungspfads (F1, F2) innerhalb des Abgabeverteilers (130) beinhaltet, wobei das Verfahren ferner Folgendes beinhaltet:
Bereitstellen der ersten Verteilungskammerauslassöffnung (112AS1, 112AS2), so dass die Öffnung (112AS1, 112AS2) eine Längsachse hat, die im Wesentlichen parallel zur einer x-Achse des Injektors (100) angeordnet ist;
Bereitstellen der ersten und zweiten Zwischenkammerauslassöffnung (122AS1, 122AS2), so dass jede eine Längsachse hat, die im Wesentlichen parallel zur x-Achse des Injektors (100) angeordnet ist; und
Bereitstellen der ersten im Wesentlichen länglichen Verteilungskammerauslassöffnung (112AS1, 112AS2) und der ersten und zweiten länglichen Zwischenkammerauslassöffnungen (122AS1, 122AS2), so dass Längsachsen davon die Scheitelpunkte eines gleichseitigen Dreiecks in einer Richtung parallel zur x-Achse betrachtet definieren.

14. Verfahren nach Anspruch 13:
wobei das Erzeugen des Flusses von Gas durch eine Verteilungskammer (110A), eine Zwischenkammer (120A, 120B) und einen Abgabeverteiler (130) das Erzeugen des Flusses von Gas durch eine im Wesentlichen längliche Verteilungskammer (110A), eine im Wesentlichen längliche Zwischenkammer (120A, 120B) und einen im Wesentlichen länglichen Abgabeverteiler (130) beinhaltet; und/oder
wobei das Herstellen eines Flusses von Gas durch den Injektor (100) von einem Gaseinlass (102) zu einer Abgabeöffnung (132S) das Herstellen eines Flusses von Gas durch den Injektor (100) von einem Gaseinlass (102) zu einer länglichen Abgabeöffnung (132S) beinhaltet und das Zulassen der Passage eines Gases durch wenigstens eine erste Verteilungskammerauslassöffnung (112AS1, 112AS2) das Zulassen der Passage eines Gases durch wenigstens eine erste im Wesentlichen längliche Verteilungskammerauslassöffnung (112AS1, 112AS2) beinhaltet; und/oder
das Bewirken beinhaltet, dass der Fluss von Gas beim Gebrauch durch die Zwischenkammer (120A, 120B) im Wesentlichen gleichmäßig zwischen dem ersten und zweiten Strömunspfad (F1, F2) unterteilt wird; und/oder
das Bewirken beinhaltet, dass der Fluss von Gas durch die Zwischenkammer (120A, 120B) zwischen dem ersten und zweiten Strömungspfad (F1, F2) durch Ablenkmittel (122A) unterteilt wird, das optional das Bereitstellen des Ablenkmittels (122A) in Form einer Wand der Zwischenkammer beinhaltet, die zwischen der ersten und zweiten Zwischenkammerauslassöffhung (122A, 122B) angeordnet ist und die Zwischenkammer (120A, 120B) vom Abgabeverteiler (130) abtrennt; und/oder
das Bewirken beinhaltet, dass das Gas durch eine erste Verteilungskammerauslassöffnung (112AS1, 112AS2) fließt, die in einer Verteilungskammeröffhungsplatte (112A) vorgesehen ist, wobei die Verteilungskammeröffhungsplatte (112A) zwischen der Verteilungskammer (110A) und der Zwischenkammer (120A, 120B) vorgesehen ist; und/oder
das Bereitstellen der Verteilungskammer (110A), der Zwischenkammer (120A, 120B) und des Abgabeverteilers (130) so beinhaltet, dass sie im Wesentlichen parallele Längsachsen haben, wobei optional die Verteilungskammer (110A), die Zwischenkammer (120A, 120B) und der Abgabeverteiler (130) so ausgelegt sind, dass ihre Längsachsen im Wesentlichen parallel zur x-Achse des Injektors (110) sind.

15. Verfahren nach Anspruch 13 oder 14, das das Bereitstellen von mehreren Verteilungskammerauslassöffnungen (112AS1, 112AS2) an beabstandeten Stellen beinhaltet, wobei optional die mehreren Verteilungskammerauslassöffnungen (112AS1, 112AS2) im Wesentlichen kollinear sind.

## Revendications

1. Injecteur (100) destiné à injecter un gaz dans un système de dépôt de matières, l'injecteur (100) comprenant :
un orifice d'admission de gaz (102) pour l'accouplement de l'injecteur à une source de gaz ;
une chambre de distribution (110A), une chambre intermédiaire (120A) et un collecteur de distribution (130) couplés en série pour constituer un trajet de circulation pour le gaz entre l'orifice d'admission (102) et au moins une ouverture de distribution (132S) à travers laquelle le gaz peut être injecté dans le système de dépôt,
l'injecteur (100) comportant au moins une première ouverture de sortie de la chambre de distribution (112AS1, 112AS2) à travers laquelle le gaz peut s'écouler depuis la chambre de distribution (110A) vers la chambre intermédiaire (120A) et au moins des première et seconde ouvertures de sortie de chambre intermédiaire (122AS1, 122AS2) à travers lesquelles le gaz peut s'écouler depuis la chambre intermédiaire (120A) vers le collecteur de distribution (130),
la chambre intermédiaire (120A) étant placée pour diviser un écoulement de gaz la traversant entre les premier et second trajets de circulation (F1, F2), les première et seconde ouvertures de sortie de chambre intermédiaire (122AS1, 122AS2) étant placées dans les premier et second trajets de circulation (F1, F2) respectifs, l'injecteur (100) étant placé pour permettre aux premier et second trajets de circulation (F1, F2) de converger au sein du collecteur de distribution (130),
dans lequel chacune de l'ouverture de la chambre de distribution (112AS1, 112AS2), de l'ouverture de la chambre intermédiaire (122AS1, 122AS2) et de l'ouverture du collecteur de distribution (132S) est d'une forme allongée,
dans lequel la première ouverture de sortie de la chambre de distribution (112AS1, 112AS2) a un axe longitudinal placé sensiblement parallèle à un axe x de l'injecteur,
dans lequel les première et seconde ouvertures de sortie de la chambre intermédiaire (122AS1, 122AS2) ont chacune un axe longitudinal placé sensiblement parallèle à l'axe x de l'injecteur (100), et
dans lequel les axes longitudinaux de la première ouverture de sortie de la chambre de distribution sensiblement allongée (112AS1, 112AS2) et les première et seconde ouvertures de sortie de la chambre intermédiaire allongée (122AS1, 122AS2) définissent les apex d'un triangle équilatéral tel qu'observé le long d'une direction parallèle à l'axe x.

2. Injecteur (100) selon l'une des revendications précédentes, dans lequel l'écoulement de gaz, lors de l'utilisation, par la chambre intermédiaire (120A) est divisé sensiblement également entre les premier et second trajets de circulation (F1, F2).

3. Injecteur (100) selon l'une des revendications précédentes, dans lequel l'écoulement de gaz, lors de l'utilisation, par la chambre intermédiaire (120A) est divisé entre les premier et second trajets de circulation (F1, F2) par un moyen formant des chicanes (122A).

4. Injecteur (100) selon la revendication 3, dans lequel le moyen formant des chicanes (122A) est obtenu par une paroi de la chambre intermédiaire (120A) placée entre les première et seconde ouvertures de sortie de la chambre intermédiaire (122AS1, 122AS2) et divisant la chambre intermédiaire (120A) du collecteur de distribution (130).

5. Injecteur (100) selon l'une des revendications précédentes, dans lequel une plaque d'ouvertures de la chambre de distribution (112A) est placée entre la chambre de distribution (110A) et la chambre intermédiaire (120A, 120B), la plaque d'ouvertures de la chambre de distribution (112A) ayant une première ouverture de sortie de la chambre de distribution (112AS1, 112AS2) placée dans celle-ci.

6. Injecteur selon l'une des revendications précédentes, dans lequel la chambre de distribution (110A), la chambre intermédiaire (120A) et le collecteur de distribution (130) ont chacun des axes longitudinaux sensiblement parallèles, éventuellement dans lequel les axes longitudinaux de la chambre de distribution (110A), de la chambre intermédiaire (120A) et du collecteur de distribution (130) sont sensiblement parallèles à l'axe x de l'injecteur (100).

7. Injecteur (100) selon l'une des revendications précédentes, dans lequel l'injecteur (100) comprend une pluralité d'ouvertures de sortie de la chambre de distribution (112AS1, 112AS2) placées à des emplacements espacés, dans lequel, éventuellement :
la pluralité d'ouvertures de sortie de la chambre de distribution (112AS1, 112AS2) sont sensiblement colinéaires ; et/ou
une longueur de chaque ouverture de sortie de la chambre de distribution (112AS1, 112AS2) diminue en fonction de la distance de l'orifice d'admission (102).

8. Injecteur (100) selon l'une des revendications précédentes, comprenant des première et seconde parties (100A, 100B) respectives, dans lequel :
les première et seconde parties ont une chambre de distribution (110A) respective ou partagent une chambre de distribution (110A) commune ;
les première et seconde parties ont chacune une chambre intermédiaire (120A, 120B) respective ; et
les première et seconde parties ont un collecteur de distribution (130) respectif ou partagent un collecteur de distribution (130) commun,
chaque partie comprenant en outre au moins une ouverture de sortie de la chambre de distribution (112AS1, 112AS2) et au moins des première et seconde ouvertures de sortie de la chambre intermédiaire allongée (122AS1, 122AS2), dans lequel le gaz, lors de l'utilisation, entrant dans l'injecteur (100) par l'orifice d'admission de gaz (102) est divisé entre les chambres de distribution (110A) des première et seconde parties (100A, 100B).

9. Injecteur (100) selon la revendication 8 :
dans lequel les première et seconde parties (100A, 100B) partagent un axe longitudinal commun, et/ou
dans lequel les chambres intermédiaires (120A, 120B) respectives sont séparées l'une de l'autre par un moyen formant une barrière (104), et/ou
dans lequel les première et seconde parties (100A, 100B) partagent une chambre de distribution (110A) commune, et/ou
dans lequel les première et seconde parties partagent un collecteur de distribution (130) commun, et/ou
dans lequel les première et seconde parties partagent une ouverture de distribution (132S) commune, et/ou
dans lequel les première et seconde parties partagent un orifice d'admission (102) commun, et/ou
dans lequel l'injecteur (100) est placé pour être sensiblement symétrique autour d'un plan perpendiculaire à un axe longitudinal de celui-ci entre les première et seconde parties (100A, 100B).

10. Injecteur (100) selon l'une des revendications précédentes, dans lequel au moins une des ouvertures (232) comprend une pluralité de sous-ouvertures (232S'), éventuellement dans lequel la pluralité de sous-ouvertures (232S') sont sensiblement circulaires.

11. Système de dépôt de matières comprenant une région de dépôt dans laquelle le dépôt de matières a lieu sur un substrat et au moins un injecteur (100) selon l'une des revendications précédentes.

12. Système selon la revendication 11, comprenant au moins un injecteur (100) placé pour injecter un gaz de dépôt, lors de l'utilisation, dans la région de dépôt, le gaz de dépôt comprenant une matière à déposer sur un substrat.

13. Procédé d'injection de gaz dans un système de dépôt de matières au moyen d'un injecteur (100), comprenant :
l'établissement d'un écoulement de gaz par l'injecteur (100) depuis une admission de gaz (102) à une ouverture de distribution allongée (132S) de celui-ci, ce qui permet au gaz de s'écouler par une chambre de distribution (110A), une chambre intermédiaire (120A, 120B) et un collecteur de distribution (130) couplés en série,
le procédé consistant à permettre au gaz de se dilater au sein de la chambre de distribution (110A) et de passer par au moins une première ouverture de sortie de la chambre de distribution (112AS1, 112AS2) dans la chambre intermédiaire (120A), l'écoulement de gaz étant placé pour s'écouler le long d'un du premier et du second trajet de circulation (F1, F2) par une première ou une seconde ouverture de sortie de la chambre intermédiaire (122AS1, 122AS2) placée dans les premier et second trajets de circulation (F1, F2) respectivement,
le procédé consistant à permettre aux premier et second trajets de circulation (F1, F2) de converger au sein du collecteur de distribution (130), dans lequel le procédé consiste en outre à :
fournir la première ouverture de sortie de la chambre de distribution (112AS1, 112AS2), ce qui permet à l'ouverture (112AS1, 112AS2) d'avoir un axe longitudinal placé sensiblement parallèle à un axe x de l'injecteur (100) ;
fournir les première et seconde ouvertures de sortie de la chambre intermédiaire (122AS1, 122AS2), ce qui permet à chacune d'avoir un axe longitudinal placé sensiblement parallèle à l'axe x de l'injecteur (100) ; et
fournir la première ouverture de sortie de la chambre de distribution sensiblement allongée (112AS1, 112AS2) et les première et seconde ouvertures de sortie de la chambre intermédiaire allongée (122AS1, 122AS2) de sorte que les axes longitudinaux de celles-ci définissent les apex d'un triangle équilatéral tel qu'observé le long d'une direction parallèle à l'axe x.

14. Procédé selon la revendication 13 :
par lequel l'établissement d'un écoulement de gaz par une chambre de distribution (110A), une chambre intermédiaire (120A, 120B) et un collecteur de distribution (130) comprend l'établissement de l'écoulement de gaz par une chambre de distribution sensiblement allongée (110A), une chambre intermédiaire sensiblement allongée (120A, 120B) et un collecteur de distribution sensiblement allongé (130) ; et/ou
par lequel l'établissement d'un écoulement de gaz par l'injecteur (100) d'une admission de gaz (102) à une ouverture de distribution (132S) comprend l'établissement d'un écoulement de gaz par l'injecteur (100) d'une admission de gaz (102) à une ouverture de distribution allongée (132S) et permettre à un gaz de passer par au moins une première ouverture de sortie de la chambre de distribution (112AS1, 112AS2) consiste à permettre à un gaz de passer par au moins une première ouverture de sortie de la chambre de distribution sensiblement allongée (112AS1, 112AS2) ; et/ou
consistant à amener l'écoulement de gaz lors de l'utilisation par la chambre intermédiaire (120A, 120B) à être divisé sensiblement également entre les premier et second trajets de circulation (F1, F2) ; et/ou
consistant à amener l'écoulement de gaz par la chambre intermédiaire (120A, 120B) à être divisé entre les premier et second trajets de circulation (F1, F2) par un moyen formant des chicanes (122A), éventuellement consistant à fournir le moyen formant des chicanes (122A) sous la forme d'une paroi de la chambre intermédiaire placée entre les première et seconde ouvertures de sortie de la chambre intermédiaire (122A, 122B) et divisant la chambre intermédiaire (120A, 120B) du collecteur de distribution (130) ; et/ou
consistant à amener le gaz à s'écouler par une première ouverture de sortie de la chambre de distribution (112AS1, 112AS2) placée dans une plaque d'ouvertures de la chambre de distribution (112A), la plaque d'ouvertures de la chambre de distribution (112A) étant placée entre la chambre de distribution (110A) et la chambre intermédiaire (120A, 120B) ; et/ou
consistant à placer la chambre de distribution (110A), la chambre intermédiaire (120A, 120B) et le collecteur de distribution (130) de sorte qu'ils ont des axes longitudinaux sensiblement parallèles, dans lequel éventuellement la chambre de distribution (110A), la chambre intermédiaire (120A, 120B) et le collecteur de distribution (130) sont agencés de telle sorte que leurs axes longitudinaux sont sensiblement parallèles à l'axe x de l'injecteur (110).

15. Procédé selon l'une quelconque des revendications 13 ou 14, consistant à placer une pluralité d'ouvertures de sortie de la chambre de distribution (112AS1, 112AS2) à des emplacements espacés, dans lequel éventuellement la pluralité d'ouvertures de sortie de la chambre de distribution (112AS1, 112AS2) sont sensiblement colinéaires.
